# EUROPEAN PATENT SPECIFICATION

(11) **EP 2 156 468 B1**
(45) Date of publication and mention of the grant of the patent: **27.07.2011**
(21) Application number: 07869868.5
(22) Date of filing: 24.12.2007
(51) Int. Cl.: H01L 25/065

(54) **SEMICONDUCTOR DEVICE HAVING MULTIPLE DIE REDISTRIBUTION LAYER**
HALBLEITERANORDNUNG MIT EINER MEHRFACH-CHIP-UMVERDRAHTUNGSSCHICHT
DISPOSITIF À SEMI-CONDUCTEURS COMPORTANT UNE COUCHE DE REDISTRIBUTION MULTIPUCE

(30) Priority: 28.12.2006 US 617689; 28.12.2006 US 617687
(43) Date of publication of application: 24.02.2010
(73) Proprietor: Sandisk Corporation, Milpitas, CA 95035 (US)
(72) Inventor: TAKIAR, Hem, Fremont, CA 94539 (US); BHAGATH, Shrikar, San Jose, CA 95120 (US)
(74) Representative: Tothill, John Paul
(86) International application number: PCT/US2007/088782
(87) International publication number: WO 2008/083133

(56) References cited:
- US-A- 5 789 816
- US-A- 5 976 911
- US-A1- 2004 017 003

## Description

### BACKGROUND OF THE INVENTION

### Field of the Invention

Embodiments of the present invention relate to a multiple die redistribution layer for a semiconductor device and methods of forming same.

### Description of the Related Art

The strong growth in demand for portable consumer electronics is driving the need for high-capacity storage devices. Non-volatile semiconductor memory devices, such as flash memory storage cards, are becoming widely used to meet the ever-growing demands on digital information storage and exchange. Their portability, versatility and rugged design, along with their high reliability and large capacity, have made such memory devices ideal for use in a wide variety of electronic devices, including for example digital cameras, digital music players, video game consoles, PDAs and cellular telephones.

While a wide variety of packaging configurations are known, flash memory storage cards may in general be fabricated as system-in-a-package (SiP) or multichip modules (MCM), where a plurality of die are mounted on a substrate. The substrate may in general include a rigid, dielectric base having a conductive layer etched on one or both sides. Electrical connections are formed between the die and the conductive layer(s), and the conductive layer(s) provide an electric lead structure for connection of the die to a host device. Once electrical connections between the die and substrate are made, the assembly is then typically encased in a molding compound to provide a protective package.

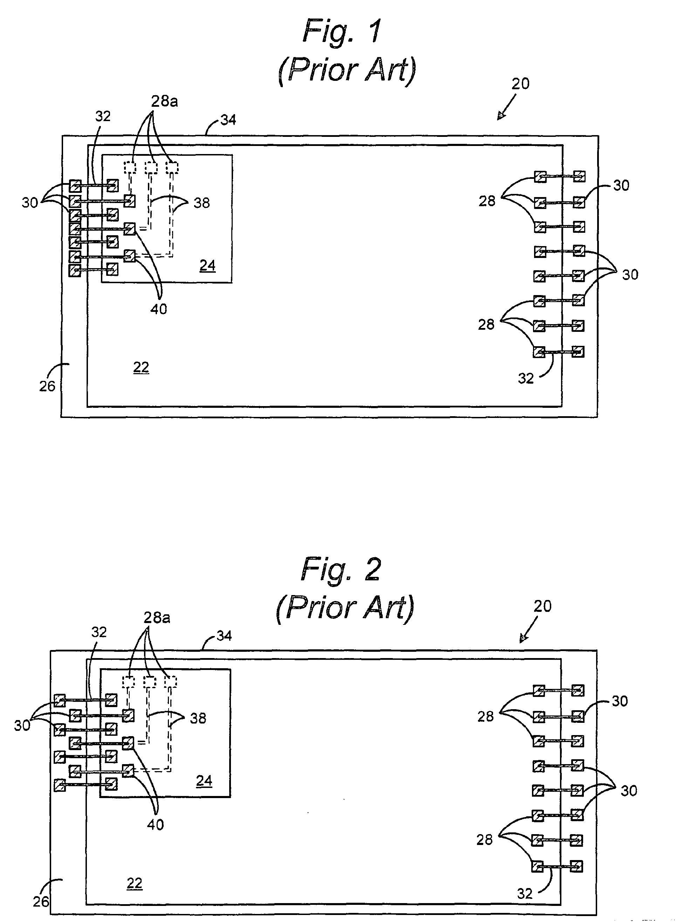

A top view of a conventional semiconductor package 20 (without molding compound) is shown in Fig. 1. Typical packages include a plurality of semiconductor die, such as die 22 and 24, affixed to a substrate 26. A plurality of die bond pads 28 may be formed on the semiconductor die 22, 24 during the die fabrication process. Similarly, a plurality of contact pads 30 may be formed on the substrate. Die 22 may be affixed to the substrate 26, and then die 24 may be mounted on die 22. Both die are then electrically coupled to the substrate by affixing wire bonds 32 between respective die bond pad 28 and contact pad 30 pairs.

Space within the semiconductor package is at a premium. Semiconductor die are often formed with bond pads along two adjacent sides, such as shown on die 24 in Fig. 1. However, owing to the significant real estate limitations, there may only be room on the substrate for a wire bond connection along one edge of the die. Thus, in Fig. 1, there are no contact pads along edge 34 of substrate 26 for connecting with die bond pads 28a.

One known method of handling this situation is through the use of a redistribution layer formed on a semiconductor die. After a semiconductor die is fabricated and singulated from the wafer, the die may undergo a process where electrically conductive traces and bond pads (traces 38 and bond pads 40, Fig. 1) are formed on the top surface of the die. Once formed, the traces 38 and bond pads 28a may be covered with an insulator, leaving only the newly formed die bond pads 40 exposed. The traces 38 connect the existing die bond pads 28a with the newly formed die bond pads 40 to effectively relocate the die bond pads to an edge of the die having a pin-out connection to the substrate. Additional contact pads 30 may be formed on the substrate to allow electrical connection between the substrate and the bond pads 28a. The additional contact pads 30 may be formed in-line with the remaining contact pads 30 as shown in prior art Fig. 1. Alternatively, where there is available space, the additional contact pads may be staggered with the remaining contact pads as shown in prior art Fig. 2. Redistribution layers as described above are shown for example in US 6,762,117, US 6,348,728 and US 2005/0139985A.

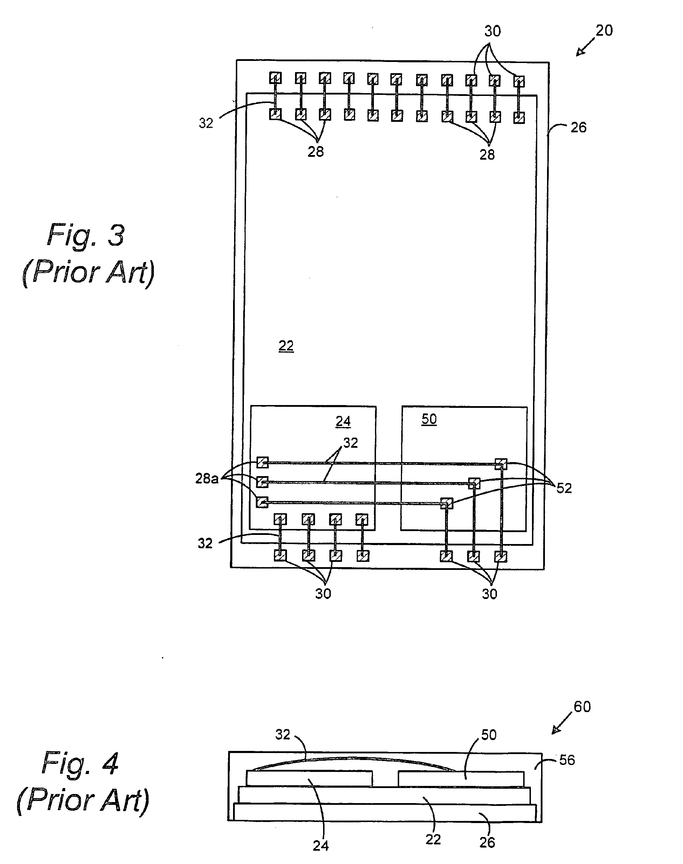

As innovations in semiconductor fabrication have increased the signal capabilities of semiconductor die, the ability to transfer those signals to the substrate has become a limiting factor. Often, there simply is not enough room on a substrate for contact pads to support all of the pin-out connections from a semiconductor die. Finding space for substrate contact pads becomes an even bigger problem when die bond pads from one side of a die are relocated with a redistribution layer to another side already having bond pads. Referring to prior art Fig. 3, it is therefore further known to provide a dummy "jumper" die 50 along side a first die, such as die 24. Die 50 may simply be a block of silicon or other material without internal circuitry but having bond pads 52 on its surface. As shown in Fig. 3, wire bonds 32 may connect die bond pads 28a on the first die with the die bond pads 52 on the dummy die, and wire bonds 32 may then connect die bond pads 52 with the contact pads 30 on the substrate. The bond pads 52 on jumper die 50 are used to effectively relocate bond pads 28a on the first die 24 to a location along the edge of the substrate having room for a contact pad.

Prior art Fig. 4 is an edge view of the jumper die arrangement shown in Fig. 3 encapsulated in a molding compound 56 to form a finished semiconductor package 60. As shown, the wire bonds 32 coupling die 24 and 50 extend above the surfaces of die 24 and 50. While low profile wire bonding is known, such as for example reverse bonding, such low profile wire bonding techniques are not available in the context of the wire bond between die 24 and 50. While it is known to redistribute the die bond pads 28a from the first side of die 24 to the side of die 24 adjacent die 50 using a redistribution layer, a jumper bond wire is still required to electrically couple die 24 and 50. US 2004/0017003 A1 describes a semiconductor device having a multi-chip configuration. The device uses relay chips to route connections via wires.

As with space considerations on the substrate, there is also a push to decrease the thicknesses of semiconductor packages. While semiconductor die may at present be made quite thin (less than a mil (25.4 µm)), the height of the wire bond required in the above-described jumper die arrangement makes such an arrangement impractical for low thickness packages. There is therefore a need for a low thickness solution having adequate pin-out positions along a side of a substrate.

### SUMMARY OF THE INVENTION

According to the present invention there is provided a semiconductor device as claimed in claim 1 and a method of forming a semiconductor device as claimed in claim 9. In an embodiment, after fabrication of semiconductor die on a wafer and prior to singulation from the wafer, adjacent semiconductor die are paired together and a redistribution layer may be formed across the die pair. The redistribution layer may be used to redistribute at least a portion of the bond pads from the first die in the pair to a second die in the pair. One die in each pair will be a working die and the other die in each pair will be a dummy die. The function of the integrated circuit beneath the redistribution layer on the dummy die is at least partially sacrificed.

The redistribution layer may be formed on the die pair by layering and etching successive dielectric and metal layers in a photolithographic process. Upon completion, one or more die bond pads on the working die may be redistributed to positions on the dummy die having a pin-out position for bonding to a substrate. For example, where a semiconductor die includes pads along two edges, but there is only room on the substrate for pin-out connections along one of the edges, the bond pads along the remaining edge may be relocated to the dummy die where they may then be wire bonded to the substrate. It is understood that die bond pads from any location on the first semiconductor die of the pair may be redistributed to any location on the second semiconductor die of the pair by a redistribution layer formed across the die at the wafer level.

After the redistribution layer is formed, the semiconductor wafer may be singulated from the wafer, with each die pair singulated as a single component. The die pair may be mounted on a substrate, together with one or more other semiconductor die. Thereafter, the die bond pads of die pair may be wire bonded to the substrate and the semiconductor die and substrate encapsulated to form a semiconductor package. In embodiments, the package may function as a flash memory device, where the working die is a controller such as an ASIC. Other semiconductor devices are contemplated.

### DESCRIPTION OF THE DRAWINGS

Figure 1 is a top view of a conventional semiconductor package including a semiconductor die having a redistribution layer to redistribute die bond pads from a first edge to a second edge of the die.

Figure 2 is a top view of a conventional semiconductor package including a die having a redistribution layer as in Fig. 1 with an alternative substrate contact pad arrangement.

Figure 3 is a top view of a conventional semiconductor package including a jumper die and jumper bond wires for redistributing the bond pads of a working die.

Figure 4 is an edge view of a conventional semiconductor package shown in prior art Fig. 3.

Figures 5 and 6 are top views of a semiconductor wafer for use in accordance with the present invention.

Figure 7 is a flowchart for the fabrication steps of a redistribution layer and semiconductor device formed thereby according to an embodiment of the present invention.

Figure 8 is a top view of a semiconductor die pair from the wafer shown in Figs. 5 and 6.

Figure 9 is a cross-sectional view through line 9-9 in Fig. 8.

Figure 10 is a top view of the semiconductor die pair after a first step in forming the redistribution layer according to an embodiment of the present invention.

Figure 11 is a cross-sectional view through line 11-11 in Fig. 10.

Figure 12 is a top view of the semiconductor die pair after a second step in forming the redistribution layer according to an embodiment of the present invention.

Figure 13 is a cross-sectional view through line 13-13 in Fig. 12.

Figure 14 is a top view of the semiconductor die pair after a first step in forming the redistribution layer according to an embodiment of the present invention.

Figure 15 is a cross-sectional view through line 15-15 in Fig. 14.

Figure 16 is a top view of the semiconductor die pair after a first step in forming the redistribution layer according to an embodiment of the present invention.

Figure 17 is a cross-sectional view through line 17-17 in Fig. 16.

Figure 18 is a top view of the semiconductor die pair after a first step in forming the redistribution layer according to an embodiment of the present invention.

Figure 19 is a cross-sectional view through line 19-19 in Fig. 18.

Figure 20 is a top view of the semiconductor die pair after a first step in forming the redistribution layer according to an embodiment of the present invention.

Figure 21 is a cross-sectional view through line 21-21 in Fig. 20.

Figure 22 is a top view of an alternative embodiment of a redistribution layer on a die pair according to the present invention.

Figure 23 is a top view of the semiconductor wafer including a redistribution layer formed thereon according to an embodiment of the present invention.

Figure 24 is a top view of a semiconductor package including a die pair fabricated to include a redistribution layer.

Figure 25 is an edge view of a semiconductor package having a die pair with a redistribution layer encapsulated in molding compound according to an embodiment of the present invention.

### DETAILED DESCRIPTION

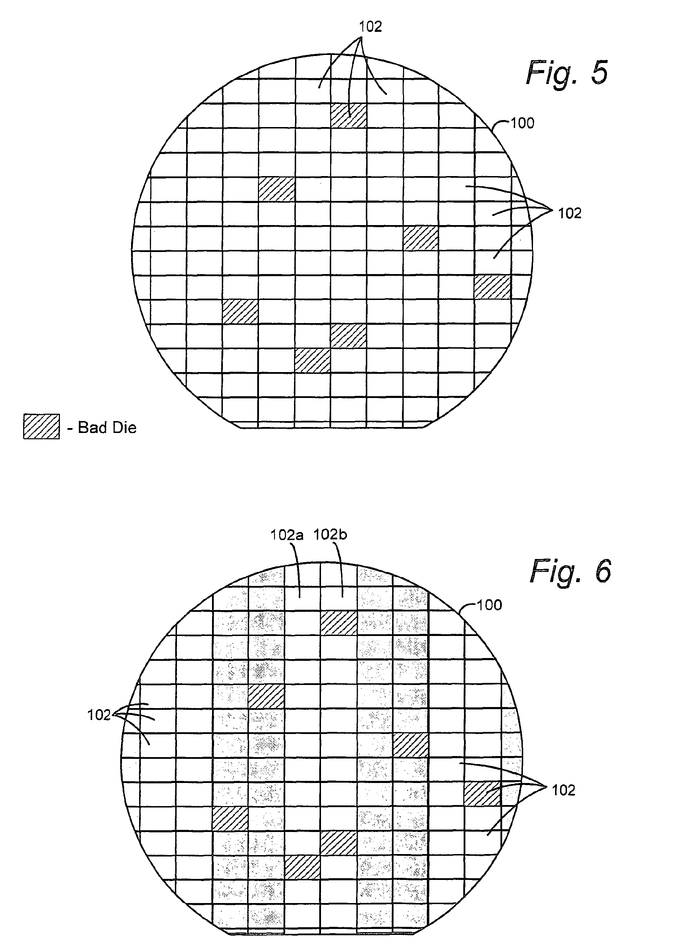

Embodiments of the present invention will now be described with reference to Figs. 5 through 25, which relate to a multiple die redistribution layer for a semiconductor device and methods of forming same. It is understood that the present invention may be embodied in many different forms and should not be construed as being limited to the embodiments set forth herein. Rather, these embodiments are provided so that this disclosure will be thorough and complete and will fully convey the invention to those skilled in the art. Indeed, the invention is intended to cover alternatives, modifications and equivalents of these embodiments, which are included within the scope of the invention as defined by the appended claims. Furthermore, in the following detailed description of the present invention, numerous specific details are set forth in order to provide a thorough understanding of the present invention. However, it will be clear to those of ordinary skill in the art that the present invention may be practiced without such specific details.

Referring now to Fig. 5, there is shown a top view of a semiconductor wafer 100 including a plurality of semiconductor die 102. Each semiconductor die 102 on wafer 100 has been processed to include an integrated circuit as is known in the art capable of performing a specified electronic function. All of semiconductor die 102 on wafer 100 may have the same integrated circuit, though it is contemplated that different die may have different integrated circuits in alternative embodiments. As is known in the art, the respective integrated circuits may be tested during wafer fabrication to identify defective or bad die, indicated in Fig. 5 with shading.

Upon completion of wafer fabrication testing, normally each of the die 102 would be singulated into individual die and thereafter assembled into a semiconductor package. However, according to an embodiment of the present invention, adjacent die 102 on wafer 100 are paired off, and a redistribution layer is formed across the surface of the die pairs as explained below. As shown in Fig. 6, adjacent die in a row may be paired to form columns of paired die on the wafer (as indicated by the alternate shading of columns in Fig. 6). Although embodiments of the present invention described hereinafter include die pairs, it is understood that more than two die may be grouped together, and thereafter a single redistribution layer may be formed across all die in the respective groups. In such an embodiment, the number of rows and/or columns in a group may vary.

In embodiments where semiconductor die 102 are grouped in pairs, one die in each pair will be the working die 102a and the other die in each pair will be a dummy die 102b. As explained hereinafter, when the redistribution layer is formed on the dummy die, the function of the integrated circuit beneath the redistribution layer on the dummy die is at least partially sacrificed.

In embodiments, the decision of how to layout the redistribution layer on the water may be based in part on the number and location of the bad die to maximize the number of bad die used as dummy die. For example, in the embodiment in Fig. 6, in each die pair, the left die may be the working die and the right die may be the dummy die (it may be otherwise in alternative embodiments). By selecting to position the columns for the working and dummy die as shown in Fig. 6, five of the seven bad die will be used as dummy die, and only two bad die are positioned as working die. The decision of how to layout the columns of paired die may be made independent of the location of bad die in embodiments of the present invention.

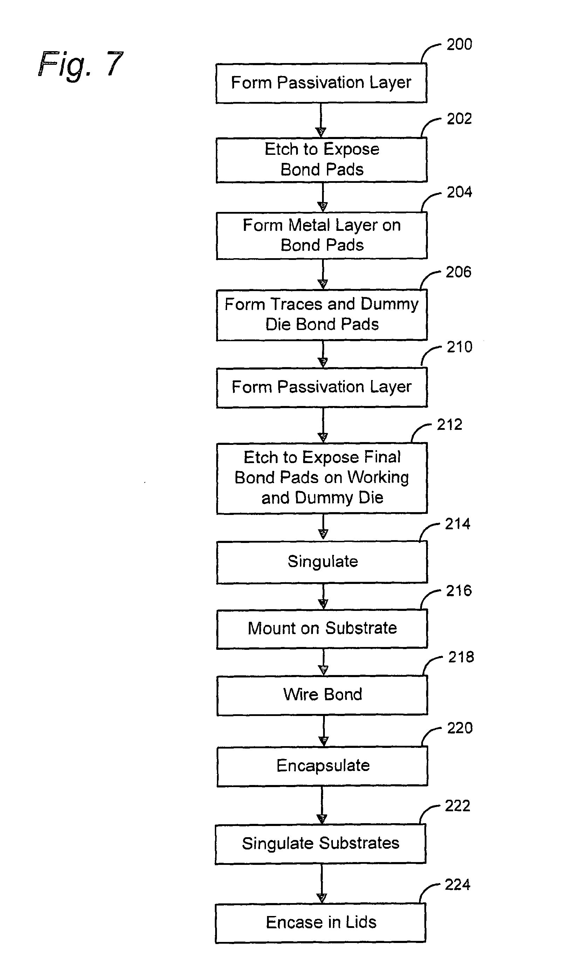

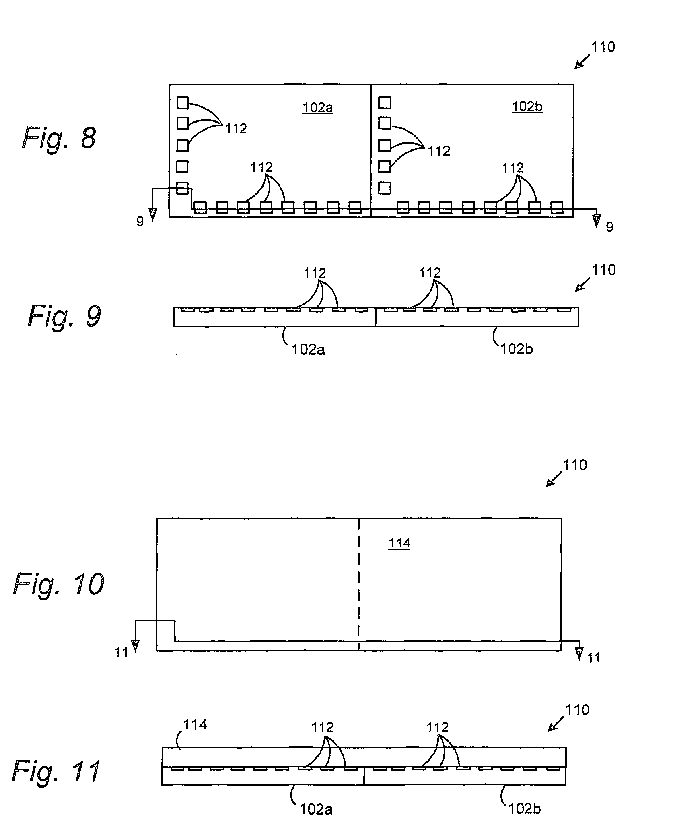

The process for forming a redistribution layer on each die pair and a semiconductor device formed therefrom is explained hereinafter with respect to the flowchart of Fig. 7 and the respective top and edge views of Figs. 8-21. The following description applies to all paired die on wafer 100. The top and edge views of Figs. 8 and 9 show a die pair 110 from wafer 100 including a pair of semiconductor die 102a and 102b. Each semiconductor die 102a, 102b may include a plurality of die bond pads 112 exposed on a surface of the die for electrically coupling the die to a substrate or other component. The die bond pads 112 formed on the surface of the semiconductor die prior to application of the redistribution layer explained hereinafter may be referred to as inner bond pads. In the embodiment shown, each semiconductor die 102a, 102b includes inner bond pads along two adjacent edges. It is understood that each semiconductor die 102a, 102b may be formed with die bond pads 112 along a single edge, along two opposed edges, along three edges or around all four edges in alternative embodiments.

Referring now to the flowchart of Fig. 7 and the top and edge views of Figs. 10 and 11, a passivation layer 114 may be applied to the semiconductor die pair 110 to cover all bond pads 112 on die 102a, 102b in a step 200. Passivation layer 114 may be any number of dielectric materials, such as for example photo-definable benzocyclobutane or other known suitable materials, applied in a known process.

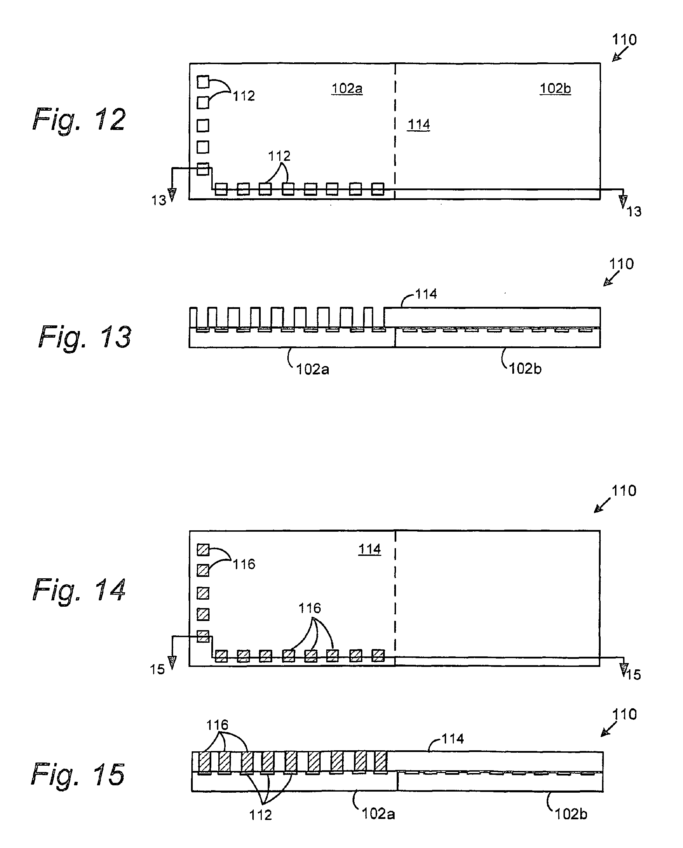

Referring now to the top and edge views of Figs. 12 and 13, in a step 202, passivation layer 114 may be etched to expose all die bond pads 112 on semiconductor die 102a. The die bond pads 112 on semiconductor die 102b remain covered by passivation layer 114. Passivation layer 114 may be etched using known photolithography and etching techniques to expose die bond pads 112 on semiconductor die 102a.

Referring now to Figs. 14 and 15, in step 204, an electrical conductor may be deposited on the die bond pads 112 exposed in the etching process of step 202. The electrical conductor may for example be gold, aluminum, copper, nickel or alloys thereof. In embodiments using for example gold, a barrier metal may be deposed between the bond pads and the gold layer to enhance bonding and conductive properties. The electrical conductor 116 may be applied on bond pads 112 by known deposition processes, such as for example sputtering. Once the metal conductor has been applied, the upper surface of the semiconductor die pair 110 may be polished to provide an even, flat surface.

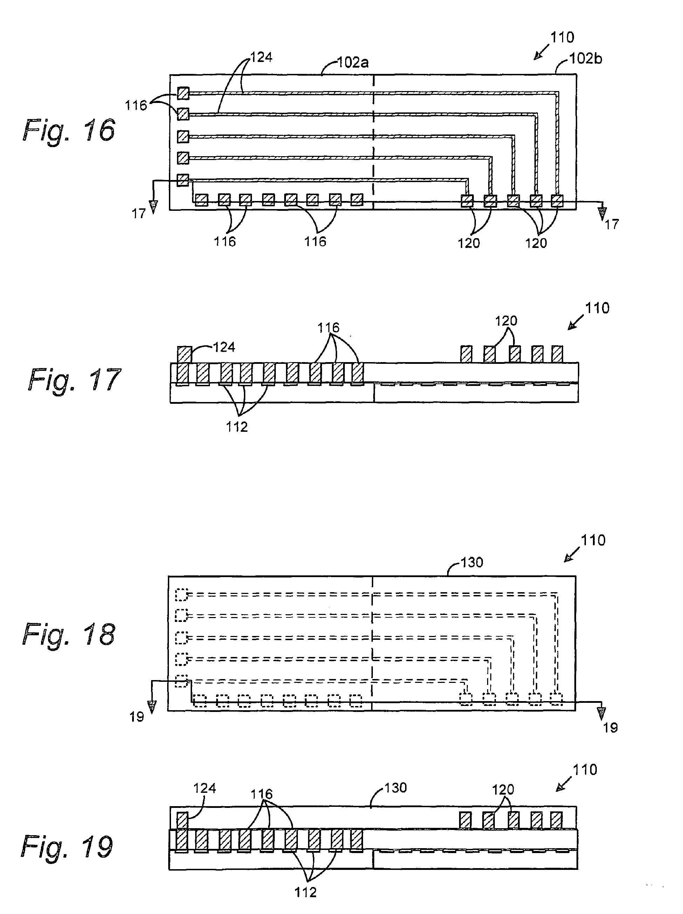

Referring now to Figs. 16 and 17, in step 206, a layer of metal may be applied on the top surface of semiconductor die pair 110 and then photolithographically processed to define a plurality of die bond pads 120 on semiconductor die 102b and a plurality of electrical traces 124. The electrical traces 124 extend between and electrically couple certain of the die bond pads 112 on die 102a (via connection with the electrical conductor 116 on pads 112) with the newly formed die bond pads 120 on die 102b. In particular, the die bond pads 112 on die 102a coupled to traces 124 are those die bond pads which are to be redistributed from the working die 102a to the bond pads 120 on dummy die 102b. In the embodiment shown, all of the die bond pads 112 along the left edge of semiconductor die 102a are relocated to the bottom edge of semiconductor die 102b. As will be explained hereinafter, die bond pads at other locations on semiconductor die 102a may be redistributed to other locations on semiconductor die 102b.

Referring now to Figs. 18 and 19, in step 210, a second passivation layer 130 may next be applied to the top surface of semiconductor die pair 110 to cover all electrical conductors 116, die bond pads 120 and metal traces 124. Passivation layer 130 may be the same as passivation layer 114 described above.

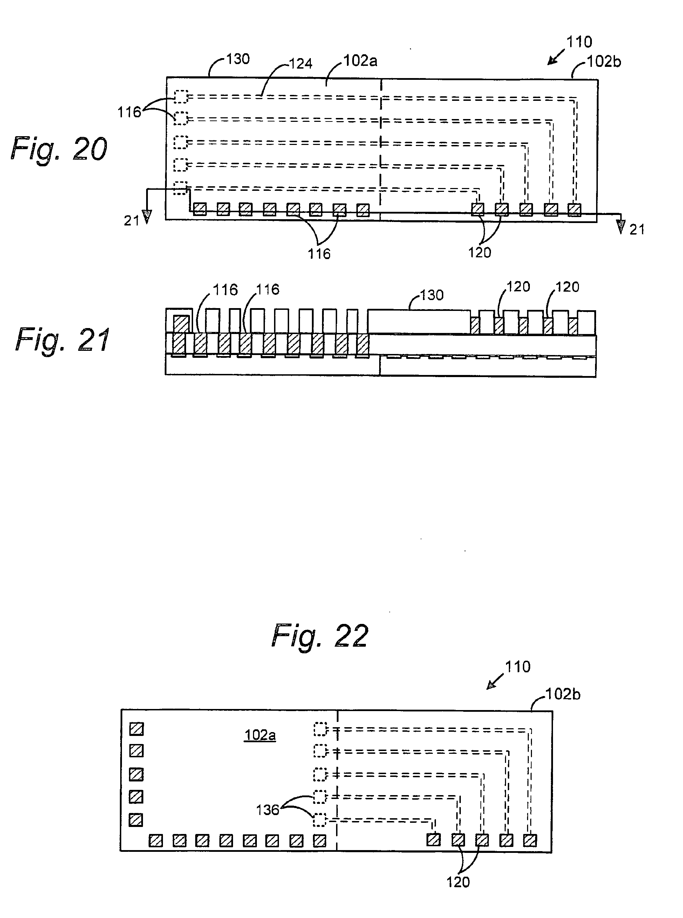

Referring now to Figs. 20 and 21, in step 212, passivation layer 130 may be etched to expose the final locations of the die bond pads on the semiconductor die pair 110. For example, in the embodiment shown, the passivation layer 130 may be etched using known photolithography and etching techniques to expose electrical conductors 116 along the bottom edge of semiconductor die 102a and the die bond pads 120 on semiconductor die 102b. The electrical conductors 116 along the left edge of die 102a may remain embedded within and covered by passivation layer 130. The electrical conductors 116 and bond pads 120 which are exposed at the surface of the redistribution layer after the above-described steps may be referred to as the outer bond pads.

Steps 206 and 210 described above result in the electrical conductors 116 forming outer bond pads which are at a different elevation than outer bond pads 120. Referring back to Figs. 16 and 17, the metal layer that was applied and patterned in step 206 to define traces 124 and die bond pads 120 may also be applied over the electrical conductors 116 along the bottom edge of die 102a. In such an embodiment, after application (step 210) and etching (step 212) of passivation layer 130, the final positions of the outer die bond pads on the die 102a and 102b may all be at the same elevation.

The above-described steps are one of many possible processes for forming a redistribution layer on adjacent die pairs at the wafer level for redistributing the die bond pads from one die to the next. Moreover, Figs. 8-21 show a particular embodiment where die bond pads along a first edge of die 102a are redistributed to a second edge of die 102b. It is understood that using the above-described or other redistribution layer process steps, die bond pads from any location on a first semiconductor die may be redistributed to any location on a second semiconductor die by a redistribution layer across the die formed at the wafer level. For example, Fig. 22 shows a top view of a semiconductor die 102a initially having die bond pads formed along three edges of the die. Using the above-described process steps, a column of die bond pads 136 on die 102a may be redistributed to bond pads 120 and die 102b. Other possible configurations are contemplated.

In the above-described steps, none of the inner bond pads 112 on dummy die 102b are used after formation of the redistribution layer. However, in alternative embodiments, not all of the bond pads 112 on dummy die 102b may go unused. Some of the inner bond pads on dummy die 102b may also be electrically coupled to outer bond pads on dummy die 102b (or redistributed to another die) where there is an available pin-out location to a substrate. In such an embodiment, the dummy die 102b may serve two functions. The die 102b may provide outer bond pads which serve as redistribution points for the inner bond pads on working die 102a. The die 102b may also operate at least in part as a working die where signals from the integrated circuit on the 102b are communicated to the substrate.

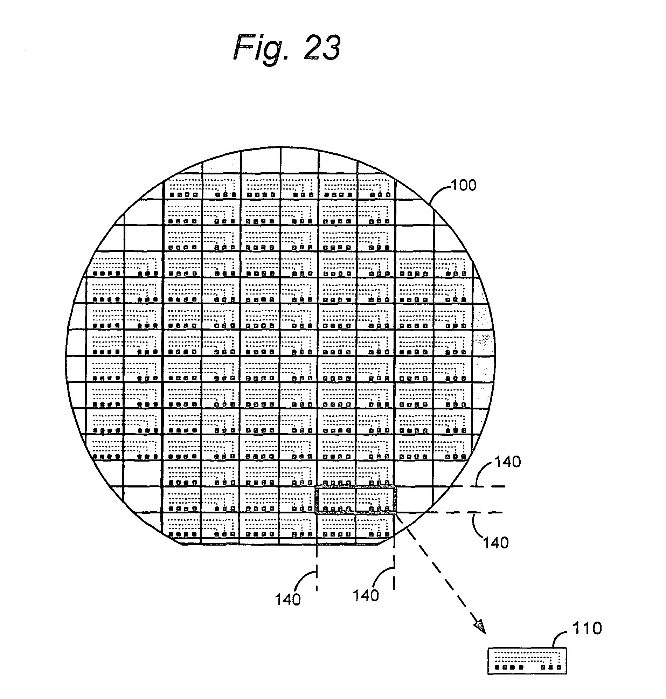

Referring now to Fig. 23, at the completion of the above-described steps, after formation of the redistribution layer on respective wafer pairs, the semiconductor wafer may be singulated from the wafer 100 in a step 214. As indicated by the dashed cutting lines 140, each die pair 110 may be singulated as a single component. As indicated above, a group of die on which a single redistribution layer is formed may be one row and two columns, but groups of die which are singulated together may include other numbers of rows and/or columns in alternative embodiments.

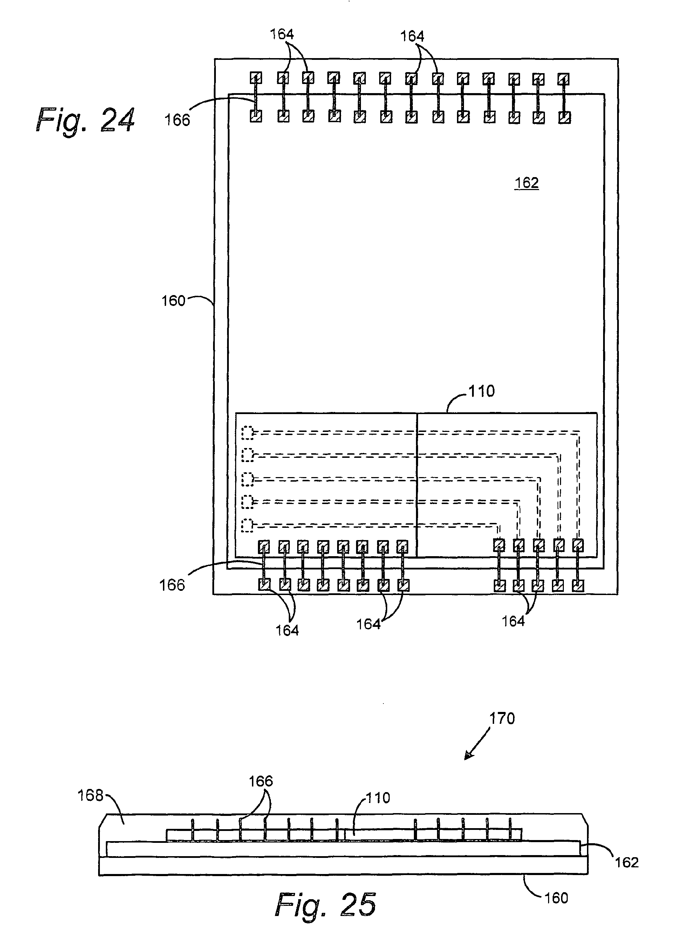

Referring now to Fig. 24, in step 216, the die pair 110 may be mounted on a substrate 160 of a panel of substrates 160 batch processed together. The die pair 110 may be the only die mounted on a substrate 160, or the die pair 110 may be mounted to substrate 160 along with one or more additional die 162 as shown in Fig. 24. Thereafter, in step 218, the outer die bond pads on die pair 110 and any other die may be wire bonded to contact pads 164 on substrate 160 using wire bonds 166 in a known wire bond process. In embodiments, the die and substrate together may function as a flash memory device, where die 102a is a controller such as an ASIC, die 102b is a dummy die for redistributing bond pads from die 102a and die 162 is a flash memory die. The die pair 110 may be other than a controller and dummy die in alternative embodiments, and the die and substrate together may be other than a flash memory device in alternative embodiments.

As explained in the Background of the Invention, in some package configurations, there is room for pin-out locations only along a single edge of a semiconductor die. As seen in Fig. 24, the redistribution layer applied to semiconductor die pair 110 effectively redistributes the bond pads from die 102a to a position on die 102b where they can be easily bonded to substrate 160. The relative lengths and relative widths of the semiconductor die pair 110, semiconductor die 162 and substrate 160 shown in Fig. 24 is by way of example only and may vary widely in alternative embodiments of the present invention.

As shown in Fig. 25, after forming the stacked die configuration according to any of the above described embodiments, the panel of substrates including the individual semiconductor packages may be encased within the molding compound 168 in step 220, and singulated from the panel in step 222, to form a finished semiconductor die package 170. Molding compound 168 may be a known epoxy such as for example available from Sumitomo Corp. and Nitto Denko Corp., both having headquarters in Japan. Thereafter, the finished package 170 may optionally be enclosed within a lid in step 224.

The foregoing detailed description of the invention has been presented for purposes of illustration and description. It is not intended to be exhaustive or to limit the invention to the precise form disclosed. Many modifications and variations are possible in light of the above teaching. The described embodiments were chosen in order to best explain the principles of the invention and its practical application to thereby enable others skilled in the art to best utilize the invention in various embodiments and with various modifications as are suited to the particular use contemplated. It is intended that the scope of the invention be defined by the claims appended hereto.

## Claims

1. A semiconductor device, comprising:
a first semiconductor die (102a) having internal circuitry, a first set of inner bond pads (112) electrically connected to the internal circuitry of the first semiconductor die (102a), and a first edge;
a second semiconductor die (102b) contiguous with the first semiconductor die (102a) and having internal circuitry, a second set of inner bond pads (112) electrically connected to the internal circuitry of the second semiconductor die (102b), and a second edge adjacent the first edge of the first semiconductor die; and
a redistribution layer formed on surfaces of the first and second semiconductor die (102a, 102b) and including:
a set of outer bond pads (120) on at least the second semiconductor die (102b) for electrically connecting the first semiconductor die (102a) with an external device, and
an electrical connection (124) between one of the inner bond pads of the first set of inner bond pads (112) on the first semiconductor die (102a) and an outer bond pad of the set of outer bond pads (120) on the second semiconductor die (102b), the redistribution layer being arranged such that at least a majority of inner bond pads of the second set of inner bond pads (112) on the second semiconductor die (102a) have no electrical connection to an external device.

2. A semiconductor device as recited in claim 1, the set of outer bond pads (120) on at least the second semiconductor die (102b) further comprising outer bond pads (116) on the first semiconductor die (102a).

3. A semiconductor device as recited in claim 1 or 2, the first and second semiconductor die (102a, 102b) being singulated as a single component (110) from a semiconductor wafer (100).

4. A semiconductor device as recited in claim 1, 2 or 3 wherein none of the inner bond pads (112) of the second semiconductor die (102b) have an electrical connection to an external device.

5. A semiconductor device as recited in any one of the preceding claims, wherein the set of outer bond pads (120) of the redistribution layer are capable of connecting to the external device via electrical leads wire (166) bonded to the set of outer bond pads (120).

6. A semiconductor device as recited in claim 5, wherein the electrical leads (166) are low loop wire bonds.

7. A semiconductor device as recited in any one of claims 1 to 4, wherein the set of outer bond pads (120) of the redistribution layer are capable of connecting to the external device via solder balls soldered to the set of outer bond pads (120).

8. A semiconductor device as recited in any one of the preceding claims, wherein the first semiconductor die (102a) is one of a microprocessor, an application-specific integrated circuit and a flash memory circuit.

9. A method of forming a semiconductor device comprising the steps of:
(a) forming a plurality of semiconductor die (102) on a wafer (100);
(b) applying a redistribution layer to a pair of contiguous semiconductor die (110) on the wafer (100), the redistribution layer relocating a bond pad (112) on the first semiconductor die (102a) of the pair to a bond pad (120) on the second semiconductor die (102b) of the pair; and
(c) singulating the first and second semiconductor die (102a, 102b) together as a single component.

10. A method as recited in claim 9, said step (b) of applying a redistribution layer to a pair of contiguous semiconductor die (110) on the wafer (100) comprising the step of sacrificing the function of the circuitry within the second semiconductor die (102b).

11. A method as recited in claim 9 or 10, further comprising the step (d) of singulating a second group of semiconductor die not including the first and second semiconductor die (102a, 102b) from the wafer (100), the second group including nine contiguous semiconductor die in three rows of three, said step (d) comprising the step of singulating the second group into nine separate semiconductor die.

12. A method as recited in claim 9, 10 or 11, further comprising the step (e) of mounting the pair of singulated semiconductor die (110) on a host device.

13. A method as recited in claim 12, further comprising the step (f) of electrically connecting the bond pad (120) on the second semiconductor die (102b) to the host device.

14. A method as recited in claim 13, said step (f) comprising the step of attaching one of a wire bond loop (116) or a solder ball to the bond pad (120) on the second semiconductor die (102b).

15. A method as recited in claim 12, 13 or 14, further comprising the step (g) of encapsulating at least the first and second semiconductor die (102a, 102b) in a molding compound (168).

## Patentansprüche

1. Halbleitervorrichtung mit:
einem ersten Halbleiter-Die bzw. Chipkern (102a) mit einer internen Schaltung, einem ersten Satz innerer Bond-Pads bzw. Bondierungspunkte (112), die elektrisch mit der internen Schaltung des ersten Halbleiter-Chipkerns (102a) verbunden sind, und einer ersten Kante;
einem zweiten Halbleiter-Chipkern (102b), der mit dem ersten Halbleiter-Chipkern (102a) zusammenhängt und eine interne Schaltung, einen zweiten Satz innerer Bondierungspunkte (112), die elektrisch mit der internen Schaltung des zweiten Halbleiter-Chipkerns (102b) verbunden sind, und eine zweite Kante die neben der ersten Kante des ersten Halbleiter-Chipkerns liegt, aufweist; und
einer Verteilungsschicht, die auf Oberflächen des ersten und des zweiten Halbleiter-Chipkerns (102a, 102b) ausgebildet ist, und die umfasst:
einen Satz äußerer Bondierungspunkte (120) auf zumindest dem zweiten Halbleiter-Chipkern (102b) zum elektrischen Verbinden des externen Halbleiter-Chipkerns (102a) mit einer externen Vorrichtung, und
eine elektrische Verbindung (124) zwischen einem der inneren Bondierungspunkte des ersten Satzes innerer Bondierungspunkte (112) auf dem ersten Halbleiter-Chipkern (102a) und einem äußeren Bondierungspunkt des Satzes äußerer Bondierungspunkte (120) auf dem zweiten Halbleiter-Chipkern (102b), wobei die Verteilungsschicht so angeordnet ist, dass wenigstens eine Mehrzahl innerer Bondierungspunkte des zweiten Satzes innerer Bondierungspunkte (112) auf dem zweiten Halbleiter-Chipkern (102a) keine elektrische Verbindung mit einer externen Vorrichtung aufweist.

2. Halbleitervorrichtung nach Anspruch 1, wobei der Satz äußerer Bondierungspunkte (120) auf wenigstens dem zweiten Halbleiter-Chipkern (102b) ferner äußere Bondierungspunkte (116) auf dem ersten Halbleiter-Chipkern (102a) aufweist.

3. Halbleitervorrichtung nach Anspruch 1 oder 2, wobei der erste und zweite Halbleiter-Chipkern (102a, 102b) als Einzelkomponente (110) aus einem Halbleiter-Wafer (100) vereinzelt sind bzw. werden.

4. Halbleitervorrichtung nach Anspruch 1, 2 oder 3, bei der keiner der inneren Bondierungspunkte (112) des zweiten Halbleiterchipkerns (102b) eine elektrische Verbindung mit einer externen Vorrichtung aufweist.

5. Halbleitervorrichtung nach einem der vorstehenden Ansprüche, wobei der Satz äußerer Bondierungspunkte (120) der Verteilungsschicht in der Lage ist, mit der elektrischen Vorrichtung über elektrische Leitungsdrähte (166) verbunden zu werden, die mit dem Satz der äußeren Bondierungspunkte (120) verbunden sind.

6. Halbleitervorrichtung nach Anspruch 5, bei der die elektrischen Leitungen (166) Schleifendrahtverbindungen sind.

7. Halbleitervorrichtung nach einem der Ansprüche 1 bis 4, bei der der Satz äußerer Bondierungspunkte (120) der Verteilungsschicht dazu in der Lage ist, mit der externen Vorrichtung über Lötpunkte verbunden zu werden, die an dem Satz äußerer Bondierungspunkte (120) angelötet sind.

8. Halbleitervorrichtung nach einem der vorstehenden Ansprüche, bei der der erste Halbleiter-Chipkern (102a) einen Mikroprozessor, eine applikationsspezifische integrierte Schaltung oder eine Flashspeicherschaltung ist.

9. Verfahren zur Herstellung einer Halbleitervorrichtung, das die Schritte umfasst:
(a) Ausbilden einer Anzahl von Halbleiterchipkernen (102) auf einem Wafer (100);
(b) Aufbringen einer Verteilungsschicht auf ein Paar zusammenhängender Halbleiter-Chipkerne (110) auf dem Wafer (100), wobei die Verteilungsschicht einen Bondierungspunkt (112) auf dem ersten Halbleiter-Chipkern (102a) des Paars mit einem Bondierungspunkt (120) auf dem zweiten Halbleiter-Chipkern (102b) des Paars reloziert; und
(c) Vereinzeln der ersten und zweiten Halbleiter-Chipkerne (102a, 102b) zusammen als Einzelkomponente.

10. Verfahren nach Anspruch 9, wobei der Schritt (b) des Aufbringens einer Verteilungsschicht auf ein Paar verbundener Halbleiter-Chipkerne (110) auf dem Wafer (100) den Schritt des Opferns der Funktion der Schaltung in dem zweiten Halbleiter-Chipkern (102b) umfasst.

11. Verfahren nach Anspruch 9 oder 10, das ferner den Schritt (d) beinhaltet, eine zweite Gruppe von HalbleiterChipkernen aus dem Wafer (100) zu vereinzeln, die nicht die ersten und zweiten Halbleiter-Chipkerne (102a, 102b) beinhalten, wobei die zweite Gruppe neun zusammenhängende Halbleiter-Chipkerne in drei Reihen von drei beinhaltet, wobei der Schritt (d) den Schritt umfasst, die zweite Gruppe in neun getrennte Halbleiter-Chipkerne zu vereinzeln.

12. Verfahren nach Anspruch 9, 10 oder 11, das ferner den Schritt (i) umfasst, das Paar vereinzelter Halbleiter-Chipkerne (110) auf einer Host-Vorrichtung anzubringen.

13. Verfahren nach Anspruch 12, das ferner den Schritt (f) umfasst, den Bondierungspunkt (120) auf dem zweiten Halbleiter-Chipkern (102b) mit der Host-Vorrichtung elektrisch zu verbinden.

14. Verfahren nach Anspruch 13, wobei der Schritt (f) den Schritt umfasst, eine Drahtverbindungsschleife (116) oder einen Lötpunkt mit dem Bondierungspunkt (120) auf dem zweiten Halbleiter-Chipkern (102b) zu verbinden.

15. Verfahren nach Anspruch 12, 13 oder 14, das ferner den Schritt (g) beinhaltet, zumindest den ersten und zweiten Halbleiter-Chipkern (102a, 102b) in einem Gussverbund (168) einzukapseln.

## Revendications

1. Dispositif à semi-conducteur, comportant :
une première puce de semi-conducteur (102a) ayant des circuits internes, un premier ensemble de plots de connexion intérieurs (112) électriquement connectés aux circuits internes de la première puce de semi-conducteur (102a), et un premier bord ;
une seconde puce de semi-conducteur (102b) contiguë à la première puce de semi-conducteur (102a) et ayant des circuits internes, un second ensemble de plots de connexion internes (112) électriquement connectés aux circuits internes de la seconde puce de semi-conducteur (102b), et un second bord adjacent au premier bord de la première puce de semi-conducteur ; et
une couche de redistribution formée sur des surfaces des première et seconde puces de semi-conducteur (102a, 102b) et incluant :
un ensemble de plots de connexion externes (120) sur au moins la seconde puce de semi-conducteur (102b) pour connecter électriquement la première puce de semi-conducteur (102a) à un dispositif externe, et
une connexion électrique (124) entre l'un des plots de connexion internes du premier ensemble de plots de connexion internes (112) sur la première puce de semi-conducteur (102a) et un plot de connexion externe de l'ensemble de plots de connexion externes (120) sur la seconde puce de semi-conducteur (102b),
la couche de redistribution étant disposée de telle sorte qu'au moins une majorité de plots de connexion internes du second ensemble de plots de connexion internes (112) sur la seconde puce de semi-conducteur (102a) n'a aucune connexion électrique à un dispositif externe.

2. Dispositif à semi-conducteur tel qu'exposé dans la revendication 1, l'ensemble de plots de connexion externes (120) sur au moins la seconde puce de semi-conducteur (102b) comportant en outre des plots de connexion externes (116) sur la première puce de semi-conducteur (102a).

3. Dispositif à semi-conducteur tel qu'exposé dans la revendication 1 ou 2, les première et seconde puces de semi-conducteur (102a, 102b) étant séparées sous la forme d'un composant unique (110) à partir d'une plaquette de semi-conducteur (100).

4. Dispositif à semi-conducteur tel qu'exposé dans la revendication 1, 2 ou 3, dans lequel aucun des plots de connexion internes (112) de la seconde puce de semi-conducteur (102b) n'a une connexion électrique à un dispositif externe.

5. Dispositif à semi-conducteur tel qu'exposé dans l'une quelconque des revendications précédentes, dans lequel l'ensemble de plots de connexion externes (120) de la couche de redistribution est capable de se connecter au dispositif externe via des fils de sortie électriques (166) reliés à l'ensemble de plots de connexion externes (120).

6. Dispositif à semi-conducteur tel qu'exposé dans la revendication 5, dans lequel les fils électriques (166) sont des soudures de fil en boucle basse.

7. Dispositif à semi-conducteur tel qu'exposé dans l'une quelconque des revendications 1 à 4, dans lequel l'ensemble de plots de connexion externes (120) de la couche de redistribution est capable de se connecter au dispositif externe via des billes de soudure soudées à l'ensemble de plots de connexion externes (120).

8. Dispositif à semi-conducteur tel qu'exposé dans l'une quelconque des revendications précédentes, dans lequel la première puce de semi-conducteur (102a) est un élément parmi un microprocesseur, un circuit intégré à application spécifique et un circuit de mémoire flash.

9. Procédé pour former un dispositif à semi-conducteur comportant les étapes consistant à :
(a) former une pluralité de puces de semi-conducteur (102) sur une plaquette (100) ;
(b) appliquer une couche de redistribution sur une paire de puces de semi-conducteur contiguës (110) sur la plaquette (100), la couche de redistribution déplaçant un plot de connexion (112) sur la première puce de semi-conducteur (102a) de la paire vers un plot de connexion (120) sur la seconde puce de semi-conducteur (102b) de la paire ; et
(c) séparer les première et seconde puces de semi-conducteur (102a, 102b) ensemble sous la forme d'un seul composant.

10. Procédé tel qu'exposé dans la revendication 9, ladite étape (b) d'application d'une couche de redistribution sur une paire de puces de semi-conducteur contiguës (110) sur la plaquette (100) comportant l'étape consistant à sacrifier la fonction des circuits dans la seconde puce de semi-conducteur (102b).

11. Procédé tel qu'exposé dans la revendication 9 ou 10, comportant en outre l'étape (d) de séparation d'un second groupe de puces de semi-conducteur incluant les première et seconde puces de semi-conducteurs (102a, 102b) à partir de la plaquette (100), le second groupe incluant neuf puces de semi-conducteur contiguës en trois rangées de trois, ladite étape (d) comportant l'étape consistant à séparer le second groupe en neuf puces de semi-conducteur distinctes.

12. Procédé tel qu'exposé dans la revendication 9, 10 ou 11, comportant en outre l'étape (e) consistant à monter la paire de puces de semi-conducteur séparées (110) sur un dispositif hôte.

13. Procédé tel qu'exposé dans la revendication 12, comportant également l'étape (f) consistant à connecter électriquement le plot de connexion (120) sur la seconde puce de semi-conducteur (102b) au dispositif hôte.

14. Procédé tel qu'exposé dans la revendication 13, ladite étape (f) comportant l'étape consistant à fixer un élément parmi une boucle de soudure de fil (116) ou une bille de soudure au plot de connexion (120) sur la seconde puce de semi-conducteur (102b).

15. Procédé tel qu'exposé dans la revendication 12, 13 ou 14, comportant en outre l'étape (g) consistant à encapsuler au moins les première et seconde puces de semi-conducteur (102a, 102b) dans un composé de moulage (168).
